# FASCICULE DE BREVET EUROPEEN

(11) **EP 3 588 556 B1**
(45) Date de publication et mention de la délivrance du brevet: **03.11.2021**
(21) Numéro de dépôt: 19181858.2
(22) Date de dépôt: 21.06.2019
(51) Int. Cl.: H01L 23/498, H01L 23/00, H05K 1/11, H05K 1/18, H01L 23/34, H05K 1/02, H05K 3/28

(54) **COMPOSANT ÉLECTRONIQUE DISCRET COMPRENANT UN TRANSISTOR**
DISKRETES ELEKTRONISCHES BAUTEIL UMFASSEND EINEN TRANSISTOR
DISCRETE ELECTRONIC COMPONENT COMPRISING A TRANSISTOR

(30) Priorité: 25.06.2018 FR 1855671
(43) Date de publication de la demande: 01.01.2020
(73) Titulaire: Commissariat à l'Energie Atomique et aux Energies Alternatives, 75015 Paris (FR)
(72) Inventeur: CARCOUET, Sébastien, 38054 GRENOBLE CEDEX 9 (FR); MAYNARD, Xavier, 38054 GRENOBLE CEDEX 9 (FR)
(74) Mandataire: Cabinet Beaumont

(56) Documents cités:
- US-A1- 2002 125 043
- US-A1- 2008 308 929
- US-A1- 2012 236 516
- US-A1- 2013 020 694
- US-A1- 2014 061 897
- US-A1- 2014 210 061
- US-A1- 2015 008 575

## Description

### Domaine

La présente demande concerne le domaine des composants électroniques discrets, et vise plus particulièrement un composant électronique discret comprenant un transistor.

### Exposé de l'art antérieur

De nombreux dispositifs électroniques comportant un ou plusieurs composants électroniques discrets montés sur une carte de circuit imprimé ont déjà été proposés. On a notamment proposé des convertisseurs de puissance dans lesquels un ou plusieurs transistors discrets montés sur une carte de circuit imprimé sont commandés en commutation à une fréquence relativement élevée, dite fréquence de découpage, par exemple une fréquence supérieure à 10 kHz. Dans un tel convertisseur, il est souhaitable que la vitesse de commutation (vitesse d'ouverture et vitesse de fermeture) des transistors soit la plus élevée possible. Ceci permet en effet d'augmenter la fréquence de commutation des transistors, et par conséquent de réduire les dimensions d'un ou plusieurs composants passifs (inductance(s) et/ou condensateur(s)) du convertisseur, tout en maintenant les pertes du convertisseur à un niveau relativement faible. En pratique, la vitesse de commutation des transistors est toutefois limitée, en raison notamment des inductances parasites des éléments conducteurs de connexion reliant chaque transistor à un circuit de contrôle du transistor.

US2013/020694 A1 divulgue un composant électronique discret comportant une puce semi-conductrice montée sur deux cartes de circuit imprimé, la puce et les cartes étant encapsulées dans un boîtier laissant accessibles des bornes de connexion externes du composant. Notamment ledit composant comporte une première borne externe de contrôle de source qui est électriquement connectée à une deuxième borne externe de source de conduction que à l'intérieur du boîtier d'encapsulation et isolée de ladite deuxième borne à l'extérieur du composant.

US2012/236516 A1 divulgue un composant électronique comportant une puce semi-conductrice comportant un transistor, la puce étant montée sur une carte de circuit imprimé et comportant des première, deuxième et troisième régions de métallisation et la carte de circuit imprimé comportant des première, deuxième, troisième et quatrième plots de connexion disjoints. Ladite puce est montée sur ladite carte de façon que la première métallisation de la puce soit en contact avec les premier et deuxième plots de connexion de ladite carte et que les deuxième et troisième régions de métallisation soient respectivement en contact avec les troisième et quatrième plots de connexion.

US2002/125043 A1 enseigne la mise en contact d'une métallisation d'une puce avec deux plots de connexion disjoints d'une carte de circuit intégré par une bille de soudure afin de faciliter l'inspection des contacts électriques lors d'un procédé de fabrication.

### Résumé

Ainsi, un mode de réalisation non compris dans l'invention revendiquée mais utile à la compréhension prévoit un composant électronique discret comportant :
une puce semiconductrice comportant un transistor, la puce comportant une première métallisation de connexion à une première région de conduction du transistor ; et
une carte de circuit imprimé comportant des premier et deuxième plots de connexion disjoints,
dans lequel :
   la puce est montée sur la carte de circuit imprimé de façon que la première métallisation de la puce soit en contact avec les premier et deuxième plots de connexion de la carte de circuit imprimé ; et
   l'ensemble comprenant la puce semiconductrice et la carte de circuit imprimé est encapsulé dans un boîtier en un matériau isolant laissant accessible des première et deuxième bornes de connexion du composant, connectées, à l'intérieur du boîtier, respectivement aux premier et deuxième plots de connexion de la carte de circuit imprimé.

Selon l'invention revendiquée :
la puce comprend en outre une deuxième métallisation de connexion à une deuxième région de conduction du transistor, et une troisième métallisation de connexion à une région de commande du transistor ;
la carte de circuit imprimé comprend en outre des troisième et quatrième plots de connexion disjoints ;
la puce est montée sur la carte de circuit imprimé de façon que les deuxième et troisième métallisations de la puce soient respectivement en contact avec les troisième et quatrième plots de connexion de la carte de circuit imprimé ; et
le boîtier du composant laisse accessible des troisième et quatrième bornes de connexion du composant, connectées, à l'intérieur du boîtier, respectivement aux troisième et quatrième plots de connexion de la carte de circuit imprimé.

Selon un mode de réalisation, en vue de dessus, la distance entre le deuxième plot de la carte de circuit imprimé et le quatrième plot de la carte de circuit imprimé est inférieure au dixième de la plus grande dimension de la puce.

Selon un mode de réalisation, les plots de connexion de la carte de circuit imprimé sont en métal.

Selon un mode de réalisation, les plots de connexion de la carte de circuit imprimé sont en cuivre.

Selon un mode de réalisation, le transistor est un transistor MOS, la première région de conduction étant une région de source du transistor.

Selon un mode de réalisation, la deuxième région de conduction est une région de drain du transistor et la région de commande est une région de grille du transistor.

Selon un mode de réalisation, le transistor est un transistor au nitrure de gallium, un transistor MOS au carbure de silicium, ou un transistor MOS à superjonction silicium.

Selon un mode de réalisation, les bornes de connexion du composant sont des broches métalliques.

Selon un mode de réalisation, les bornes de connexion du composant sont des plots métalliques.

### Brève description des dessins

Ces caractéristiques et leurs avantages, ainsi que d'autres, seront exposés en détail dans la description suivante de modes de réalisation particuliers faite à titre non limitatif en relation avec les figures jointes parmi lesquelles :
la figure 1A est une vue en perspective schématique d'un exemple non compris dans l'invention revendiquée mais utile à la compréhension d'un composant électronique discret comprenant un transistor ;
la figure 1B est un schéma électrique équivalent d'un dispositif électronique comportant le composant de la figure 1A et un circuit de commande de ce composant ;
la figure 2A est une vue en perspective schématique d'un autre exemple non compris dans l'invention revendiquée mais utile à la compréhension d'un composant électronique discret comprenant un transistor ;
la figure 2B est un schéma électrique équivalent d'un dispositif électronique comportant le composant de la figure 2A et un circuit de commande de ce composant ;
la figure 3A est une vue de dessous schématique d'un exemple d'une puce semiconductrice comprenant un transistor selon l'invention revendiquée ;
la figure 3B est une vue de dessus schématique d'un exemple d'une carte de circuit imprimé destinée à recevoir la puce de la figure 3A ;
la figure 3C est une vue en perspective schématique d'un exemple d'un mode de réalisation d'un composant électronique discret comportant la puce de la figure 3A montée sur la carte de circuit imprimé de la figure 3B ; et
la figure 4 est une vue en perspective schématique d'un autre exemple d'un mode de réalisation d'un composant électronique discret selon l'invention revendiquée comportant la puce de la figure 3A montée sur la carte de circuit imprimé de la figure 3B.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés. En particulier, la structure des puces semiconductrices dans et sur lesquelles sont formés les transistors des composants électroniques discrets décrits n'a pas été détaillée, les modes de réalisation décrits étant compatibles avec toutes ou la plupart des structures connues de puces de transistors. De plus, les schémas électriques complets des dispositifs électroniques dans lesquels peuvent être utilisés les composants électroniques discrets décrits n'ont pas été détaillés, les modes de réalisation décrits étant compatibles avec tous ou la plupart des dispositifs électroniques comportant des composants électroniques discrets à base de transistors, et en particulier des transistors discrets commandés en commutation, par exemple des convertisseurs à découpage.

On notera que par composant électronique discret comprenant un transistor, on entend ici un composant comprenant au moins une puce semiconductrice comprenant un transistor, et un boîtier d'encapsulation de la puce semiconductrice, par exemple en un matériau isolant, laissant accessibles au moins trois plots conducteurs de connexion à un dispositif extérieur, connectés respectivement aux deux bornes de conduction du transistor (la source et le drain dans le cas d'un transistor MOS ou dans le cas d'un transistor HEMT (de l'anglais "High Electron Mobility Transistor" - transistor à haute mobilité d'électrons), par exemple un transistor HEMT au nitrure de gallium (GaN)) et à une borne de commande du transistor (la grille dans le cas d'un transistor MOS ou dans le cas d'un transistor HEMT au GaN). Bien que les modes de réalisation décrits ne se limitent pas à ce cas particulier, on s'intéresse ici plus particulièrement à des transistors de puissance, c'est-à-dire des transistors adaptés à tenir des tensions relativement élevées à l'état ouvert (bloqué), par exemple des tensions supérieures ou égales à 100 V et de préférence supérieures ou égales à 500 V, et/ou à laisser passer des courants relativement élevés à l'état fermé (passant), par exemple des courants supérieurs ou égaux à 1 A et de préférence supérieurs ou égaux à 10 A.

Par ailleurs, on entend ici par carte de circuit imprimé ou PCB (de l'anglais "Printed Circuit Board") un support en forme de plaque adapté à maintenir et à relier électriquement à des plots de connexion au moins un composant électronique, et, éventuellement, à maintenir et à relier électriquement entre eux une pluralité de composants électroniques discrets, dans le but de réaliser un dispositif électronique complexe aussi appelé carte électronique. Une carte de circuit imprimé est par exemple constituée d'un empilement d'une couche support en un matériau isolant, et d'une ou plusieurs couches conductrices, par exemple en cuivre, séparées les unes des autres par un matériau isolant. Les couches conductrices sont localement gravées, par exemple par un procédé chimique, pour définir des plots conducteurs de connexion, et, le cas échéant, un ensemble de pistes conductrices reliant entre eux des plots de connexion de la carte de circuit imprimé.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence à l'orientation des figures, étant entendu que, en pratique, les dispositifs décrits peuvent être orientés différemment. Sauf précision contraire, les expressions "approximativement", "sensiblement", et "de l'ordre de" signifient à 10 % près, de préférence à 5 % près.

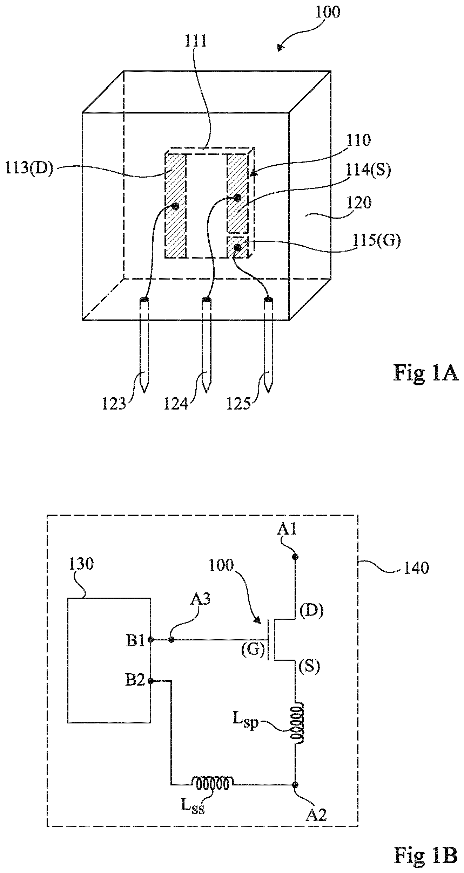

La figure 1A est une vue en perspective schématique d'un exemple non compris dans l'invention revendiquée d'un composant électronique discret 100 comprenant un transistor. Le composant 100 comprend une puce semiconductrice 110 dans et sur laquelle est formée la partie active du transistor. La puce semiconductrice 110 comprend notamment un substrat semiconducteur 111, par exemple en silicium, en carbure de silicium, en nitrure de gallium, ou en tout autre matériau semiconducteur adapté à la réalisation d'un transistor. La puce 110 comprend en outre, sur au moins une face du substrat 111, au moins trois métallisations 113, 114 et 115, en contact respectivement avec des première et deuxième régions de conduction du transistor et avec une région de commande du transistor. A titre d'exemple, le transistor est un transistor HEMT au GaN ou un transistor MOS, et les métallisations 113, 114 et 115 sont en contact respectivement avec le drain (D), la source (S) et la grille (G) du transistor. Dans cet exemple, la puce semiconductrice 110 est encapsulée dans un boîtier 120 en un matériau isolant, par exemple en résine, laissant accessibles uniquement trois éléments conducteurs ou bornes de connexion à un dispositif extérieur 123, 124 et 125, par exemple en métal. Dans l'exemple représenté, les bornes de connexion 123, 124 et 125 ont la forme de broches. A l'intérieur du boîtier 120, les bornes de connexion 123, 124 et 125 sont connectées électriquement respectivement aux métallisations 113, 114 et 115 de la puce 110. La connexion électrique entre les bornes 123, 124 et 125 et les métallisations 113, 114 et 115 peut être assurée par tous éléments conducteurs de connexion adaptés, par exemple des fils conducteurs ou des lames conductrices.

En pratique, le composant 100 est destiné à être monté sur une carte de circuit imprimé (non représentée), de façon que les bornes de connexion 123, 124, et 125 soient fixées mécaniquement à la carte de circuit imprimé et connectées électriquement à des plots conducteurs de connexion correspondant de la carte de circuit imprimé, par exemple par soudure ou par brasure. La carte de circuit imprimé peut en outre comprendre des pistes conductrices reliant les plots de connexion 123, 124 et 125 à des plots de connexion à d'autres composants discrets d'un dispositif électronique et/ou à des bornes de connexion extérieures du dispositif électronique.

La figure 1B est un schéma électrique équivalent d'un dispositif électronique comportant le composant 100 de la figure 1A et un circuit de contrôle 130 de ce composant, montés sur une carte de circuit imprimé 140. Par souci de simplification, sur la figure 1B, on a simplement représenté de façon schématique une borne A1 de la carte de circuit imprimé 140, à laquelle est connectée la borne 123 du composant 100 (correspondant au drain du transistor), une borne A2 de la carte de circuit imprimé 140, à laquelle est connectée la borne 124 du composant 100 (correspondant à la source du transistor), et une borne A3 de la carte de circuit imprimé 140, à laquelle est connectée la borne 125 du composant 100 (correspondant à la grille du transistor). En utilisation, le composant 100 a pour fonction de moduler ou de commuter un courant circulant entre les bornes A1 et A2 du dispositif. Pour cela, le circuit de contrôle 130 applique un signal électrique de commande entre les bornes A3 et A2 du dispositif. Plus particulièrement, dans le cas d'un transistor HEMT au GaN ou d'un transistor MOS, le circuit de contrôle applique une tension de commande entre la grille (par l'intermédiaire de la borne A3 et de la borne 125) et la source (par l'intermédiaire de la borne A2 et de la borne 124) du transistor pour contrôler le courant circulant entre le drain et la source du transistor. Le circuit de contrôle 130 comprend une première borne B1 connectée à la borne A3, et une deuxième borne B2 connectée à la borne 124.

Sur la figure 1B, on a représenté une première inductance Lₛₚ, reliant la source (S) du transistor du composant 100 à la borne A2, et une deuxième inductance Lₛₛ reliant la borne A2 à la borne B2 du circuit de contrôle 130. L'inductance Lₛₚ correspond à l'inductance parasite de l'ensemble des éléments conducteurs reliant la source (S) du transistor à la borne A2, correspondant principalement à l'inductance parasite de la borne de connexion 124, et, éventuellement, de la ou des pistes conductrices reliant la borne 124 à la borne A2. L'inductance Lₛₛ correspond quant à elle à l'inductance parasite de l'ensemble des éléments conducteurs reliant la borne A2 du dispositif à la borne B2 du circuit de commande 130.

Bien que les inductances parasites Lₛₚ et Lₛₛ soient très faibles, ces dernières peuvent perturber la tension grille-source effectivement vue par le transistor. En particulier, en fonctionnement, l'inductance Lₛₚ est susceptible d'être traversée par des courants importants dans la mesure où elle se situe sur le chemin de puissance principal du transistor. Lors des commutations à l'état ouvert ou à l'état fermé du transistor, une variation rapide du courant circulant dans l'inductance Lₛₚ se produit, ce qui peut générer une tension relativement élevée aux bornes de l'inductance Lₛₚ. A titre d'exemple, pour une commutation d'un courant de 50 A en une période de commutation de 5 ns, la vitesse de variation du courant dans l'inductance Lₛₚ est de 50 kA/ps. En considérant une inductance Lₛₚ de 1 nH (ce qui correspond à une longueur de piste conductrice de l'ordre de 1 mm sur une carte de circuit imprimé), la tension aux bornes de l'inductance Lₛₚ pendant la période de commutation peut atteindre 10 V. Ainsi, la tension de commande effectivement vue par le transistor est fortement influencée par l'inductance parasite Lₛₚ, ce qui peut conduire à des dysfonctionnements, voire à un claquage du transistor.

L'inductance Lₛₛ est quant à elle moins gênante dans la mesure où les courants qui la traversent sont en pratique négligeables par rapport au courant traversant l'inductance Lₛₚ.

Une solution pour limiter les dysfonctionnements évoqués ci-dessus est de limiter la vitesse de commutation du transistor. Comme indiqué ci-dessus, dans un convertisseur à découpage, ceci implique une diminution de la fréquence de découpage et par conséquent une augmentation des dimensions des composants passifs du convertisseur, ainsi qu'une augmentation des pertes de commutation.

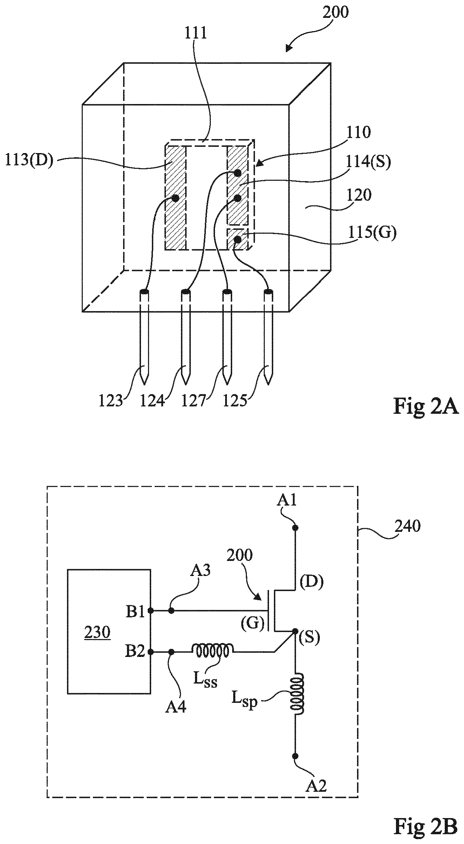

La figure 2A est une vue en perspective schématique d'un autre exemple non compris dans l'invention revendiquée d'un composant électronique discret 200 comprenant un transistor. Le composant 200 de la figure 2A comprend les mêmes éléments que le composant 100 de la figure 1A, agencés sensiblement de la même manière, et comprend en outre une borne supplémentaire 127 de connexion à un dispositif extérieur. Dans l'exemple représenté, la borne 127 est une broche de connexion similaire aux broches de connexion 123, 124 et 125, par exemple disposée sur la même face du boîtier 120 que les broches 123, 124 et 125. La borne 127 est par exemple en le même matériau conducteur que les bornes 123, 124 et 125. A l'intérieur du boîtier 120, la borne supplémentaire 127 est connectée à la région de source du transistor. Plus particulièrement, dans l'exemple représenté, à l'intérieur du boîtier 120, la borne supplémentaire 127 est connectée à la même métallisation de source 114 que la borne 124. Vu de l'extérieur, la borne supplémentaire 127 est toutefois isolée latéralement de la borne 124 par le matériau isolant du boîtier 120. Autrement dit, il n'existe pas, à l'intérieur du boîtier, de partie commune entre le chemin de connexion de la borne 124 à la métallisation 114 et le chemin de connexion de la borne 127 à la métallisation 114.

En pratique, le composant 200 est destiné à être monté sur une carte de circuit imprimé (non représentée), de façon que les bornes de connexion 123, 124, 125 et 127 soient fixées mécaniquement à la carte de circuit imprimé et connectées électriquement à des plots conducteurs de connexion correspondant de la carte de circuit imprimé, par exemple par soudure ou par brasure. La carte de circuit imprimé peut en outre comprendre des pistes conductrices reliant les plots de connexion 123, 124, 125 et 127 à des plots de connexion à d'autres composants discrets d'un dispositif électronique et/ou à des bornes de connexion extérieures du dispositif électronique.

La borne 127 constitue une borne de contrôle de source, destinée à être connectée à un circuit de contrôle du transistor, tandis que la borne 124 constitue une borne de source de conduction, destinée à être connectée sur le chemin de puissance du transistor.

La figure 2B est un schéma électrique équivalent d'un dispositif électronique comportant le composant 200 de la figure 2A et un circuit de contrôle 230 de ce composant, montés sur une carte de circuit imprimé 240. Par souci de simplification, sur la figure 2B, on a simplement représenté de façon schématique une borne A1 de la carte de circuit imprimé 240, à laquelle est connectée la borne 123 du composant 200, une borne A2 de la carte de circuit imprimé 240, à laquelle est connecté la borne 124 du composant 200, une borne A3 de la carte de circuit imprimé 240, à laquelle est connectée la borne 125 du composant 200, et une borne A4 de la carte de circuit imprimé 240, à laquelle est connectée la borne 127 du composant 200. Dans cet exemple, les bornes A2 et A4 de la carte de circuit imprimé sont disjointes, c'est-à-dire que, en l'absence du composant 200 (avant montage du composant 200 sur la carte de circuit imprimé), les bornes A2 et A4 sont électriquement isolées l'une de l'autre.

En utilisation, le composant 200 a pour fonction de moduler ou de commuter un courant circulant entre les bornes A1 et A2 du dispositif. Pour cela, le dispositif comprend un circuit de contrôle 230 connecté aux bornes A3 et A4 de la carte de circuit imprimé. En fonctionnement, le circuit de contrôle 230 applique un signal électrique de commande entre les bornes A3 et A4 du dispositif. Plus particulièrement, dans le cas d'un transistor HEMT au GaN ou d'un transistor MOS, le circuit de contrôle applique une tension de commande entre la grille (par l'intermédiaire de la borne A3 et de la borne 125) et la source (par l'intermédiaire de la borne A4 et de la borne 127) du transistor pour contrôler le courant circulant entre le drain (par l'intermédiaire des bornes A1 et 123) et la source (par l'intermédiaire des bornes 124 et A2) du transistor. Le circuit de contrôle 230 comprend une première borne B1 connectée à la borne A3 et une deuxième borne B2 connectée à la borne A4.

Sur la figure 2B, on a représenté une première inductance Lₛₚ, reliant la source (S) du transistor du composant 200 à la borne A2, et une deuxième inductance Lₛₛ reliant la source (S) du transistor à la borne B2 du circuit de contrôle 230. L'inductance Lₛₚ correspond à l'inductance parasite de l'ensemble des éléments conducteurs reliant la source (S) du transistor à la borne A2, correspondant principalement à l'inductance parasite de la borne de connexion 124, et, éventuellement, de la ou des pistes conductrices reliant la borne 124 à la borne A2. L'inductance Lₛₛ correspond quant à elle à l'inductance parasite de l'ensemble des éléments conducteurs reliant la source (S) du transistor à la borne B2, correspondant principalement à l'inductance parasite de la borne de connexion 127, et, éventuellement, de la ou des pistes conductrices reliant la borne 127 à la borne B2 (dans l'exemple représenté, l'inductance parasite de la ou des pistes conductrices reliant la borne A4 à la borne B2 est considérée comme négligeable).

Comme l'illustre le schéma de la figure 2B, la prévision, dans le composant 200, d'une borne de contrôle de source 127 distincte de la borne de source de conduction 124, et, sur la carte de circuit imprimé 240, d'une borne de contrôle de source correspondante A4 distincte de la borne de source de conduction A2, permet de rendre négligeable l'inductance parasite de connexion de source vue à la fois par le circuit de contrôle 230 et par le chemin de puissance du dispositif.

Dans la configuration des figures 2A et 2B, l'inductance Lₛₚ est toujours susceptible d'être traversée par des courants importants, ce qui peut, comme expliqué ci-dessous en relation avec la figure 1B, conduire à l'apparition d'une tension relativement élevée à ses bornes lors des commutations du transistor. Toutefois, à la différence de la configuration des figures 1A et 1B, ceci ne perturbe pas la tension de commande effectivement vue par le transistor, dans la mesure où l'inductance Lₛₚ est en dehors du chemin de connexion entre la borne B2 du circuit de contrôle et la source du transistor.

De même que dans la configuration des figures 1A et 1B, l'inductance Lₛₛ est peu gênante dans la mesure où les courants qui la traversent sont négligeables par rapport au courant traversant l'inductance Lₛₚ.

Ainsi, la configuration des figures 2A et 2B permet d'appliquer au transistor une vitesse de commutation plus élevée que dans la configuration des figures 1A et 1B, sans augmenter les risques de dysfonctionnements.

Toutefois, une difficulté est que la fabrication d'un composant du type décrit en relation avec la figure 2A est relativement complexe. En particulier, les connexions électriques, à l'intérieur du boîtier 120, entre les métallisations de la puce semiconductrice 110 et les bornes de connexion 123, 124, 125 et 127 sont délicates à réaliser, notamment en raison du volume restreint à l'intérieur du boîtier et surtout de la double connexion qui doit être réalisée sur la métallisation de source 114 du transistor.

Selon un aspect d'un mode de réalisation de l'invention revendiquée, on prévoit de disposer, à l'intérieur du boîtier d'un composant électronique discret comportant un transistor, une carte de circuit imprimé comportant deux plots de connexion disjoints, la puce semiconductrice du composant étant montée directement sur la carte de circuit imprimé interne au boîtier de façon que la métallisation de source de la puce soit en contact avec les deux plots de connexion de la carte de circuit imprimé. Le composant comprend en outre deux bornes de connexion accessibles à l'extérieur du boîtier, connectées, à l'intérieur du boîtier, respectivement aux deux plots de la carte de circuit imprimé.

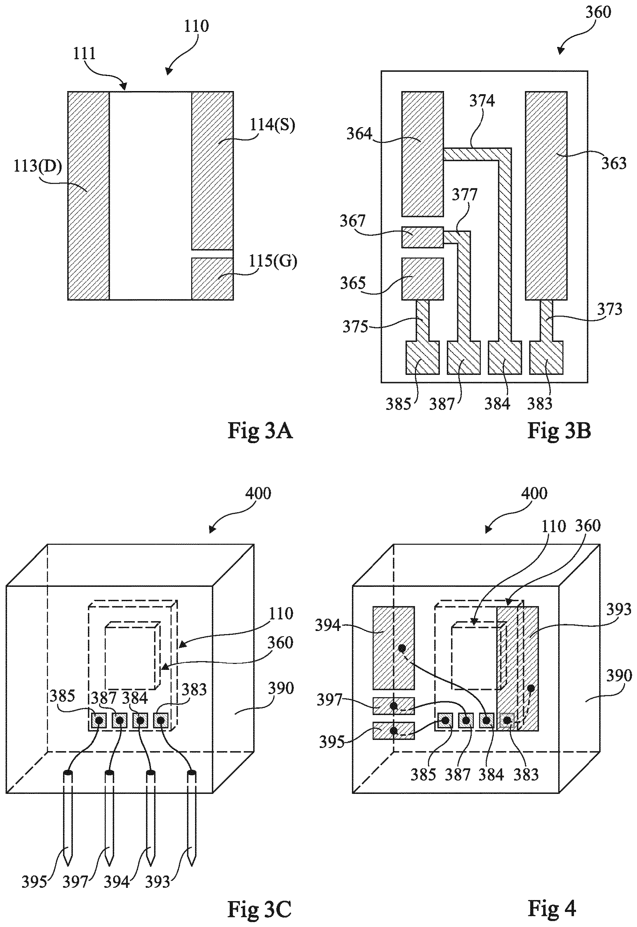

La figure 3A est une vue de dessous schématique d'un exemple de l'invention revendiquée d'une puce semiconductrice 110 d'un composant électronique discret selon un mode de réalisation. La puce 110 est par exemple identique ou similaire à la puce 110 décrite en relation avec la figure 1A. La puce 110 comprend notamment un substrat semiconducteur 111, dans et sur lequel est formé un transistor. La puce 110 comprend en outre, disposées sur une ou plusieurs faces du substrat 111, au moins trois métallisations 113, 114 et 115, en contact respectivement avec des première et deuxième régions de conduction du transistor et avec une région de commande du transistor. A titre d'exemple, le transistor est un transistor HEMT au GaN ou un transistor MOS, et les métallisations 113, 114 et 115 sont en contact respectivement avec le drain (D), la source (S) et la grille (G) du transistor. Dans cet exemple, les trois métallisations 113, 114 et 115 sont disposées sur une même face du substrat 111 (la face visible en figure 3A, à savoir la face inférieure du substrat).

La figure 3B est une vue de dessus schématique d'un exemple de l'invention revendiquée d'une carte de circuit imprimé 360 destinée à recevoir la puce 110 de la figure 3A. La carte de circuit imprimé 360 comprend, du côté de sa face supérieure, quatre plots de connexion 363, 364, 365 et 367, par exemple en métal, par exemple en cuivre. Les plots 363 et 365 sont destinés à être connectés respectivement aux métallisations de connexion 113 et 115 de la puce 110. Les plots 364 et 367 sont quant à eux tous deux destinés à être connectés à la métallisation 114 de la puce 110. Dans cet exemple, les plots 367 et 364 sont disjoints, c'est-à-dire que, en l'absence de la puce 110 (avant montage de la puce 110 sur la carte de circuit imprimé 360), les plots 364 et 367 sont électriquement isolés l'un de l'autre. Le plot 364 constitue un plot de source de conduction du composant, et le plot 367 constitue un plot de contrôle de source du composant.

Dans cet exemple, la puce 110 et la carte de circuit imprimé 360 sont destinées à être assemblées par montage en surface. Autrement dit, la face inférieure de chacune des métallisations 113 et 115 de la puce 110 est fixée et connectée électriquement, par exemple par soudure ou par brasure, à la face supérieure du plot de connexion correspondant 363, respectivement 365. De plus, la face inférieure de la métallisation 114 de la puce 110 est fixée et connectée électriquement, par exemple par soudure ou par brasure, à la fois à la face supérieure du plot 364 et à la face supérieure du plot 367.

De préférence, le plot de contrôle de source 367 de la carte de circuit imprimé 360 est voisin du plot de connexion de grille 365 de la carte de circuit imprimé, c'est-à-dire qu'il est séparé latéralement du plot 365 uniquement par le matériau isolant de la carte de circuit imprimé, et non par un autre élément conducteur de la carte de circuit imprimé. A titre d'exemple, en vue de dessus, la distance entre le plot 365 et le plot 367 est inférieure au dixième de la plus grande dimension de la puce semiconductrice 110.

La carte de circuit imprimé 360 peut en outre comprendre des pistes conductrices 373, 374, 375, 377, reliant les plots de connexion 363, 364, 365, 367 respectivement à des plots 383, 384, 385, 387 de connexion à l'extérieur de la carte de circuit imprimé 360. Dans cet exemple, les plots 383, 384, 385 et 387 de la carte de circuit imprimé 360 sont destinés à être connectés à des bornes de connexion externes du composant électronique discret.

La figure 3C est une vue en perspective schématique d'un exemple d'un mode de réalisation de l'invention revendiquée d'un composant électronique discret 400 comportant la puce 110 de la figure 3A montée sur la carte de circuit imprimé 360 de la figure 3B.

Le composant 400 comprend un boîtier 390 en un matériau isolant, par exemple en résine, dans lequel est encapsulé l'ensemble comportant la carte de circuit imprimé 360 et la puce semiconductrice 110, montée en surface sur la carte de circuit imprimé 360. Dans cet exemple, le boîtier 390 laisse accessibles quatre éléments conducteurs ou bornes de connexion à un dispositif extérieur 393, 394, 395 et 397. Dans l'exemple de la figure 3C, les bornes de connexion 393, 394, 395 et 397 ont la forme de broches. A l'intérieur du boîtier 390, les bornes de connexion 393, 394, 395 et 397 sont connectées électriquement respectivement aux plots de connexion 383, 384, 385 et 387 de la carte de circuit imprimé 360. La connexion électrique entre les bornes 393, 394, 395 et 397 et les plots de connexion correspondants 383, 384, 385 et 387 de la carte de circuit imprimé 360 peut être assurée par tous éléments conducteurs de connexion adaptés, par exemple des fils conducteurs ou des lames conductrices.

En pratique, le composant 400 est destiné à être monté sur une carte de circuit imprimé (non représentée), de façon que les bornes de connexion 393, 394, 395 et 397 du composant soient fixées mécaniquement à la carte de circuit imprimé et connectées électriquement à des plots conducteurs de connexion correspondant de la carte de circuit imprimé, par exemple par soudure ou par brasure. La carte de circuit imprimé peut en outre comprendre des pistes conductrices reliant les bornes de connexion 393, 394, 395 et 397 à des plots de connexion à d'autres composants discrets d'un dispositif électronique et/ou à des bornes de connexion extérieures du dispositif électronique. En particulier, les bornes de connexion 395 et 397 peuvent être reliées à un circuit de contrôle du composant 400, monté sur la même carte de circuit imprimé que le composant 400, pour obtenir un fonctionnement similaire à ce qui a été décrit en relation avec les figures 2A et 2B.

Un avantage du mode de réalisation d'un composant électronique discret décrit en relation avec les figures 3A, 3B et 3C est que la prévision d'une carte de circuit imprimé interne au boîtier du composant facilite la réalisation des connexions électriques entre la puce semiconductrice du composant et les bornes de connexion externe du composant, et, plus particulièrement, la réalisation de deux connexions électriques disjointes de la métallisation de source du transistor vers deux bornes de connexion externes distinctes du composant.

La figure 4 est une vue en perspective schématique d'une variante de réalisation de l'invention revendiquée du composant électronique discret 400 de la figure 3C.

Le composant 400 de la figure 4 diffère du composant 400 de la figure 3C principalement en ce que, dans l'exemple de la figure 4, les éléments conducteurs de connexion à l'extérieur 393, 394, 395 et 397 ne sont pas des broches conductrices, comme dans l'exemple de la figure 3C, mais des plots conducteurs. Dans l'exemple représenté, le boîtier 390 du composant 400 a une forme générale sensiblement parallélépipédique, les plots conducteurs 393, 394, 395 et 397 étant disposés sur une même face du boîtier, de façon à permettre un montage en surface du composant sur une carte de circuit imprimé.

Des modes de réalisation particuliers ont été décrits. Diverses variantes et modifications apparaîtront à l'homme de l'art. En particulier, on a décrit ci-dessus des exemples de réalisation appliqués à des transistors HEMT au GaN ou à des transistors MOS. Les modes de réalisation ne se limitent toutefois pas à ces cas particuliers. Plus généralement, les modes de réalisation décrits peuvent être appliqués à tout transistor comportant deux bornes de conduction et une borne de commande destiné à recevoir un signal électrique de commande référencé par rapport à l'une des bornes de conduction, par exemple des transistors bipolaires ou des transistors à effet de champ. Les modes de réalisation décrits sont notamment particulièrement adaptés aux transistors à commutation rapide. Outre les exemples mentionnés ci-dessus, les modes de réalisation décrits sont notamment particulièrement avantageux pour des transistors MOS au carbure de silicium ou pour des transistors MOS à superjonction silicium.

## Revendications

1. Composant électronique discret (400) comportant :
une puce semiconductrice (110) comportant un transistor, la puce comportant une première métallisation (114) de connexion à une première région de conduction (S) du transistor, une deuxième métallisation (113) de connexion à une deuxième région de conduction (D) du transistor, et une troisième métallisation (115) de connexion à une région de commande (G) du transistor ; et
une carte de circuit imprimé (360) comportant des premier (364), deuxième (367), troisième (363) et quatrième (365) plots de connexion disjoints,
dans lequel :
la puce (110) est montée sur la carte de circuit imprimé (360) de façon que la première métallisation (114) de la puce soit en contact avec les premier (364) et deuxième (367) plots de connexion de la carte de circuit imprimé (360), et que les deuxième (113) et troisième (115) métallisations de la puce soient respectivement en contact avec les troisième (363) et quatrième (365) plots de connexion de la carte de circuit imprimé (360) ; et
l'ensemble comprenant la puce semiconductrice (110) et la carte de circuit imprimé (360) est encapsulé dans un boîtier (390) en un matériau isolant laissant accessible des première (394), deuxième (397), troisième (393) et quatrième (395) bornes de connexion du composant, connectées, à l'intérieur du boîtier, respectivement aux premier (364), deuxième (367), troisième (363) et quatrième (365) plots de connexion de la carte de circuit imprimé (360).

2. Composant (400) selon la revendication 1, dans lequel, en vue de dessus, la distance entre le deuxième plot (367) de la carte de circuit imprimé (360) et le quatrième plot (365) de la carte de circuit imprimé (360) est inférieure au dixième de la plus grande dimension de la puce (110).

3. Composant (400) selon la revendication 1 ou 2, dans lequel les plots de connexion de la carte de circuit imprimé sont en métal.

4. Composant (400) selon la revendication 3, dans lequel les plots de connexion de la carte de circuit imprimé sont en cuivre.

5. Composant (400) selon l'une quelconque des revendications 1 à 4, dans lequel le transistor est un transistor MOS, la première région de conduction (S) étant une région de source du transistor.

6. Composant (400) selon la revendication 5, dans lequel la deuxième région de conduction (D) est une région de drain du transistor et la région de commande (G) est une région de grille du transistor.

7. Composant (400) selon l'une quelconque des revendications 1 à 6, dans lequel le transistor est un transistor au nitrure de gallium, un transistor MOS au carbure de silicium, ou un transistor MOS à superjonction silicium.

8. Composant (400) selon l'une quelconque des revendications 1 à 7, dans lequel les bornes de connexion (393, 394, 395, 397) du composant sont des broches métalliques.

9. Composant (400) selon l'une quelconque des revendications 1 à 7, dans lequel les bornes de connexion (393, 394, 395, 397) du composant sont des plots métalliques.

## Patentansprüche

1. Diskretes elektronisches Bauelement (400), das Folgendes aufweist:
einen Halbleiterchip (110) mit einem Transistor, wobei der Chip eine erste Metallisierung (114) zur Verbindung mit einem ersten Leitungsgebiet (S) des Transistors, eine zweite Metallisierung (113) zur Verbindung mit einem zweiten Leitungsgebiet (D) des Transistors und eine dritte Metallisierung (115) zur Verbindung mit einem Steuergebiet (G) des Transistors aufweist; und
eine gedruckte Leiterplatte (360), die erste (364), zweite (367), dritte (363) und vierte (365) separate Anschlussflächen aufweist,
wobei:
der Chip (110) auf der gedruckten Leiterplatte (360) so montiert ist, dass die erste Metallisierung (114) des Chips in Kontakt mit der ersten (364) und zweiten (367) Anschlussfläche der gedruckten Leiterplatte (360) ist, und dass die zweite (113) und dritte (115) Metallisierung des Chips jeweils in Kontakt mit der dritten (363) und vierten (365) Anschlussfläche der gedruckten Leiterplatte (360) ist; und
die Baugruppe, die den Halbleiterchip (110) und die Leiterplatte (360) aufweist, in einem Gehäuse (390) aus einem isolierenden Material eingekapselt ist, das den Zugang zu ersten (394), zweiten (397), dritten (393) und vierten (395) Anschlüssen des Bauelements freigibt, die im Inneren des Gehäuses mit den ersten (364), zweiten (367), dritten (363) bzw. vierten (365) Anschlussflächen der Leiterplatte (360) verbunden sind.

2. Bauelement (400) nach Anspruch 1, wobei in der Draufsicht der Abstand zwischen der zweiten Anschlussfläche (367) der Leiterplatte (360) und der vierten Anschlussfläche (365) der Leiterplatte (360) kürzer ist als ein Zehntel der größten Abmessung des Chips (110).

3. Bauelement (400) nach Anspruch 1 oder 2, wobei die Anschlussflächen der Leiterplatte aus Metall bestehen.

4. Bauelement (400) nach Anspruch 3, wobei die Anschlussflächen der Leiterplatte aus Kupfer bestehen.

5. Bauelement (400) nach einem der Ansprüche 1 bis 4, wobei der Transistor ein MOS-Transistor ist und der erste Leitungsbereich (S) ein Source-Bereich des Transistors ist.

6. Bauelement (400) nach Anspruch 5, wobei der zweite Leitungsbereich (D) ein Drain-Bereich des Transistors ist und der Steuerbereich (G) ein Gate-Bereich des Transistors ist.

7. Bauelement (400) nach einem der Ansprüche 1 bis 6, wobei der Transistor ein Galliumnitridtransistor, ein Siliziumkarbid-MOS-Transistor oder ein Silizium-Superübergangs-MOS-Transistor ist.

8. Bauelement (400) nach einem der Ansprüche 1 bis 7, wobei die Anschlüsse (393, 394, 395, 397) des Bauelements Metallstifte sind.

9. Bauelement (400) nach einem der Ansprüche 1 bis 7, wobei die Anschlüsse (393, 394, 395, 397) des Bauelements Metallanschlussflächen sind.

## Claims

1. A discrete electronic component (400) comprising:
a semiconductor chip (110) comprising a transistor, the chip comprising a first metallization (114) of connection to a first conduction region (S) of the transistor, a second metallization (113) of connection to a second conduction region (D) of the transistor, and a third metallization (115) of connection to a control region (G) of the transistor; and
a printed circuit board (360) comprising first (364), second (367), third (363), and fourth (365) separate connection pads,
wherein:
the chip (110) is assembled on the printed circuit board (360) so that the first metallization (114) of the chip is in contact with the first (364) and second (367) connection pads of the printed circuit board (360), and so that the second (113) and third (115) metallizations of the chip are respectively in contact with the third (363) and fourth (365) connection pads of the printed circuit board (360); and
the assembly comprising the semiconductor chip (110) and the printed circuit board (360) is encapsulated in a package (390) made of an insulating material leaving access to first (394), second (397), third (393), and fourth (395) connection terminals of the component, connected, inside of the package, respectively to the first (364), second (367), third (363), and fourth (365) connection pads of the printed circuit board (360).

2. The component (400) of claim 1, wherein in top view, the distance between the second pad (367) of the printed circuit board (360) and the fourth pad (365) of the printed circuit board (360) is shorter than one tenth of the largest dimension of the chip (110).

3. The component (400) of claim 1 or 2, wherein the connection pads of the printed circuit board are made of metal.

4. The component (400) of claim 3, wherein the connection pads of the printed circuit board are made of copper.

5. The component (400) of any of claims 1 to 4, wherein the transistor is a MOS transistor, the first conduction region (S) being a source region of the transistor.

6. The component (400) of claim 5, wherein the second conduction region (D) is a drain region of the transistor and the control region (G) is a gate region of the transistor.

7. The component (400) of any of claims 1 to 6, wherein the transistor is a gallium nitride transistor, a silicon carbide MOS transistor, or a silicon superjunction MOS transistor.

8. The component (400) of any of claims 1 to 7, wherein the connection terminals (393, 394, 395, 397) of the component are metal pins.

9. The component (400) of any of claims 1 to 7, wherein the connection terminals (393, 394, 395, 397) of the component are metal pads.
